(19)

Europäisches
Patentamt
European
Patent Office
Office européen
des brevets

(11)     **EP 2 213 883 A1**

(12)     **EUROPEAN PATENT APPLICATION**
published in accordance with Art. 153(4) EPC

(43) Date of publication:
    **04.08.2010 Bulletin 2010/31**

(51) Int Cl.:
    *F04D 33/00* (2006.01)      *H01M 8/04* (2006.01)

(21) Application number: **08839906.8**

(22) Date of filing: **26.09.2008**

(86) International application number:
    **PCT/JP2008/067465**

(87) International publication number:
    **WO 2009/050998 (23.04.2009 Gazette 2009/17)**

(84) Designated Contracting States:
    **AT BE BG CH CY CZ DE DK EE ES FI FR GB GR
    HR HU IE IS IT LI LT LU LV MC MT NL NO PL PT
    RO SE SI SK TR**
    Designated Extension States:
    **AL BA MK RS**

(30) Priority: **15.10.2007 JP 2007267708
                29.08.2008 JP 2008221055**

(71) Applicant: **Sanyo Electric Co., Ltd.
    Osaka 570-8677 (JP)**

(72) Inventors:
    • **NAKAGAWA, Tatsuyuki
      Moriguchi-shi
      Osaka 570-8677 (JP)**
    • **NISHIKAWA, Masato
      Moriguchi-shi
      Osaka 570-8677 (JP)**
    • **KIHARA, Hitoshi
      Moriguchi-shi
      Osaka 570-8677 (JP)**

(74) Representative: **Glawe, Delfs, Moll
    Patent- und Rechtsanwälte
    Postfach 26 01 62
    80058 München (DE)**

(54) **FLUID TRANSFER DEVICE AND FUEL CELL WITH THE SAME**

(57)     Provided are a fluid transfer device having higher efficiency than conventional devices and a fuel cell comprising the fluid transfer device.

The fluid transfer device according to the present invention comprises a loop-like elastic body 1, at least two piezoelectric elements 3, 3 arranged on the elastic body 1 along a loop direction, and at least one flow path 6 formed along a flat plate part 11 of the elastic body 1.

Voltages having phases different from each other are applied to both the piezoelectric elements 3, 3 to generate in the elastic body 1 a flexural wave advancing in the direction of the loop, and this transfers fluid in the flow path 6. The fuel cell according to the present invention comprises an MEA placed in the loop-like elastic body, and a liquid flow path and a gas flow path are formed along the MEA.

FIG. 1

EP 2 213 883 A1

**Description**

TECHNICAL FIELD

The present invention relates to a fluid transfer device transferring a fluid by flexural vibration in a ultrasonic region and a fuel cell supplying a fuel fluid and an oxidizing fluid to a membrane-electrode assembly using the fluid transfer device.

BACKGROUND ART

In recent years, there has been considered installing a fuel cell in small electronic devices such as a portable telephone as a power supply. For example, in a direct methanol type fuel cell which can be made thin in thickness, electric power is generated by supplying an oxidizing gas such as air, oxygen or the like to an air electrode, and supplying a fuel such as methanol or the like to a fuel electrode.
In the fuel cell, in order to supply an oxidizing fluid and a fuel fluid to the air electrode and the fuel electrode respectively, required is a device which transfers these fluids along the air electrode and the fuel electrode as an incidental equipment.
Conventionally, as a small fluid transfer device, there has been proposed a piezoelectric pump which circulates a refrigerant in a loop-like flow path with a plurality of flat plate type piezoelectric elements as a drive source (e.g., Japan Patent Laid-Open No. 2006-242176).
Also, as a fluid transfer device in the fuel cell, there has been proposed a device generating a traveling wave in a flat plate-like vibration plate and transferring a fluid by the traveling wave (e.g., Japan Patent Laid-Open No. 2006-269363).

DISCLOSURE OF THE INVENTION

PROBLEMS TO BE SOLVED BY THE INVENTION

However, in the above-mentioned piezoelectric pump circulating a refrigerant with the flat plate type piezoelectric elements as a drive source, the piezoelectric elements are arranged along a side surface of a loop-like elastic body which forms the flow path, and the flow path is formed along a side wall of the loop-like elastic body. Therefore, when a width of the side wall of the loop-like elastic body (a difference between an outer peripheral radius and an inner peripheral radius) is increased in order to enlarge a contact area between the side wall and the flow path, there is a great difference in length for which vibration is transmitted between outer peripheral side and inner peripheral side of the side wall. This results in a great loss, and many piezoelectric elements must be arranged along the side surface of the loop-like elastic body to obtain sufficient output.
In contrast, in the above-described fluid transfer device generating a traveling wave in a flat plate-like vibration plate and transferring a fluid by the traveling wave as a fluid transfer device in the fuel cell, the traveling wave generated in the vibration plate is reflected on an end face of the vibration plate, and therefore, the loss is great.
An object of the present invention is to provide a fluid transfer device capable of obtaining a higher efficiency than conventional devices and a fuel cell comprising the fluid transfer device.

MEANS FOR SOLVING THE PROBLEM

A first fluid transfer device according to the present invention comprises:

a loop-like elastic body;
at least two vibrating elements arranged on an outer peripheral surface or an inner peripheral surface of the elastic body along a loop direction; and
at least one flow path formed in the outer peripheral surface of the elastic body along the loop direction,
by vibrating both the vibrating elements in phases different from each other and generating a flexural wave that advances in the loop direction in the elastic body, a fluid in the flow path is transferred.

In the fluid transfer device of the present invention described above, when voltages with phases different from each other are applied to the two vibrating elements, the flexural wave that advances in the loop direction is generated in the elastic body (refer to "New Edition Ultrasonic Motor" Triceps, "CD-WS132" page 15 to page 22 for generation principle of flexural traveling wave). According to the configuration in which a flexural traveling wave is generated in the loop-like elastic body in this way, since the flexural traveling wave circulates through the elastic body in one direction without being reflected, there is little energy loss, and highly efficient excitation is realized.
Also, the two vibrating elements are arranged on the outer peripheral surface or the inner peripheral surface of the loop-like elastic body, and the flow path is formed along the outer peripheral surface of the loop-like elastic body. Therefore, even if the width of the loop-like elastic body is increased in order to enlarge the contact area between the loop-like elastic body and the flow path, since the thickness (wall thickness) of the loop-like elastic body can be minimized, there is no great difference in length with which the vibration is transmitted between outer peripheral side and inner peripheral side of the loop-like elastic body. As a result, the vibration is transmitted effectively, and sufficient output can be obtained with a simple configuration with the two vibrating elements.

A second fluid transfer device according to the present invention comprises:

a loop-like elastic body;
at least two vibrating elements arranged on an outer peripheral surface of the elastic body along a loop direction; and
two flow paths that are formed along an inner peripheral surface of the elastic body and formed by dividing into two an inner area surrounded by the elastic body with a partition wall crossing a loop that the elastic body draws,
by vibrating both the vibrating elements in phases different from each other and generating a flexural wave that advances in the loop direction in the elastic body, a fluid in each of the two flow paths is transferred.

In the fluid transfer device of the present invention described above, when voltages with phases different from each other are applied to the two vibrating elements, the flexural wave that advances in the loop direction is generated in the elastic body. Since the two flow paths are formed along the inner peripheral surface of the elastic body, a fluid in each flow path is transferred with advance of the flexural wave. Here, in a case where the elastic body is vibrated in ultrasonic wave region, vibrational energy is converted into transfer energy of the fluid with high efficiency.

Also, according to the fluid transfer device of the present invention described above, the fluid can be transferred along the two flow paths with the simple configuration in which only two vibrating elements are installed in the elastic body. Therefore, the size of the device can be decreased.

A fuel cell according to the present invention comprises a membrane-electrode assembly formed by a pair of electrodes arranged on either side of an electrolyte membrane, and a fluid transfer device supplying a fuel fluid to one electrode of the pair of electrodes of the membrane-electrode assembly and supplying an oxidizing fluid to the other electrode. The fluid transfer device comprises:

a loop-like elastic body;
at least two vibrating elements arranged on an outer peripheral surface of the elastic body along a loop direction;
two flow paths which are formed along an inner peripheral surface of the elastic body and formed by dividing into two an internal area surrounded by the elastic body with the membrane-electrode assembly placed in the internal area in such a posture that the membrane-electrode assembly crosses the loop that the elastic body draws,
by vibrating both the vibrating elements in phases different from each other and generating a flexural wave that advances in the loop direction on the elastic body, the fuel fluid is transferred along one flow path, and the oxidizing fluid is transferred along the other flow path.

In the fuel cell of the present invention described above, when voltages with phases different from each other are applied to the two vibrating elements of the fluid transfer device, the flexural wave that advances in the loop direction is generated in the elastic body. Since the two flow paths are formed along the inner peripheral surface of the elastic body, the fluid in each flow path is transferred with the advance of the flexural wave. Here, since the two flow paths extend along surfaces of two electrodes of the membrane-electrode assembly, the fuel fluid is supplied in one electrode (fuel electrode), and the oxidizing fluid is supplied to the other electrode (air electrode).

Also, carbon dioxide gas produced in the flow path on the one electrode (fuel electrode) side of the two flow paths is carried away to downstream, and water produced in the flow path on the other electrode (air electrode) side is carried away to downstream.

According to the fuel cell of the present invention described above, since the fluid transfer device has a simple configuration in which only two vibrating elements are installed in the loop-like elastic body, it is possible to decrease the size of the whole fuel cell.

In a particular configuration, the elastic body comprises two flat plate parts parallel to each other and two circular arc parts connecting corresponding ends of both the flat plate parts to each other. The membrane-electrode assembly is arranged parallel to the two flat plate parts, and the two circular arc parts are each provided with one or more apertures which is an inlet or an outlet of the two flow paths.

For the aperture, it is preferable to employ a slit aperture extending along an arc line of the circular arc part.

According to this particular configuration, since the elastic body has a flat shape, the fluid transfer device can be decreased in thickness, and moreover, since the two flow paths are formed along the two flat plate parts, energy of a traveling flexural wave generated in the flat plate part is transmitted to the fluid in the flow path effectively, and the fluid is transferred effectively.

Also, in the case where each of the inlet and the outlet of the two flow paths is formed by one or more slit apertures, the flexural wave advancing in the elastic body is not reflected greatly in one opening edge of the slit aperture, and as a result, the effective excitation of the flexural traveling wave is realized.

In a further particular configuration, the elastic body comprises a plurality of loop-like elastic body pieces arranged parallel to each other at an interval, and one or more connection pieces connecting the loop-like elastic body pieces to each other. The connection piece is provided with the aperture.

According to this particular configuration, in a case where as a material of the connecting piece, an elastic material (e.g., an alcohol resistant rubber) with a elastic coefficient sufficiently smaller than the elastic body piece (for example, made of aluminum) is employed, the flexural wave advancing in each elastic body piece is not reflected greatly by the elastic body piece, and as a result, the effective excitation of the flexural traveling wave is realized.

Also, in a particular configuration, of the two flow paths, a fuel supply tank is connected to the inlet of the flow path transferring the fuel fluid, and a produced water collection tank is connected to the outlet of the flow path transferring the oxidizing fluid.

According to this particular configuration, the fuel fluid is supplied from the fuel supply tank to the flow path on the one electrode (fuel electrode) side of the membrane-electrode assembly. Also, water which is produced in the flow path on the other electrode (air electrode) side of the membrane-electrode assembly and attached to the elastic body is moved forward by the flexural traveling wave generated in the elastic body, and is finally collected in the produced water collection tank.

In a further particular configuration, of the two flow paths, the inlet and the outlet of the flow path transferring the fuel fluid are connected to each other by a circulation flow path, and the fuel fluid which flows out from the outlet is supplied to the inlet.

According to this particular configuration, due to circulation of the fuel fluid, the fuel fluid which passes through the fuel electrode of the membrane-electrode assembly is reutilized, and the fuel is supplied sufficiently.

In a still further particular configuration, the inner peripheral surface of the elastic body is provided with concavity and convexity having a difference in level in a flow path direction along at least one flow path of the two flow paths.

According to this particular configuration, due to the generation of the flexural wave in the elastic body, a convex part of a concave-convex surface has a high vibration rate, and therefore, the fluid flowing through the flow path receives an impelling force from the convex part, and flow velocity increases.

EFFECT OF THE INVENTION

According to the fluid transfer device according to the present invention, a fluid can be transferred with higher efficiency than in conventional devices. Therefore, by employing a fuel cell of the present invention including the fluid transfer device as a power supply of an electronic device, high power generation efficiency can be obtained.

BRIEF DESCRIPTION OF THE DRAWINGS

[FIG. 1] FIG. 1 is a perspective view of a first fluid transfer device according to the present invention;
[FIG. 2] FIG. 2 is a longitudinal sectional view of the fluid transfer device;
[FIG. 3] FIG. 3 is a perspective view of a second fluid transfer device according to the present invention;
[FIG. 4] FIG. 4 is a longitudinal sectional view of the fluid transfer device;
[FIG. 5] FIG. 5 is a perspective view of the fuel cell according to the present invention;
[FIG. 6] FIG. 6 is a longitudinal sectional view of the fuel cell;
[FIG. 7] FIG. 7 is a cross-sectional view along an S-S line of FIG. 5;
[FIG. 8] FIG. 8 is a cross-sectional view along a T-T line of FIG. 6;
[FIG. 9] FIG. 9 is a perspective view showing another embodiment of the fuel cell according to the present invention;
[FIG. 10] FIG. 10 is a longitudinal sectional view of the embodiment;
[FIG. 11] FIG. 11 is a perspective view showing another embodiment of the fuel cell according to the present invention;
[FIG. 12] FIG. 12 is a longitudinal sectional view of the embodiment;
[FIG. 13] FIG. 13 is a cross-sectional view showing an essential part of an embodiment in which concavity and convexity are formed on a loop-like elastic body;
[FIG. 14] FIG. 14 is a cross-sectional view showing an essential part of an embodiment in which a produced water collection tank is installed;
[FIG. 15] FIG. 15 is a cross-sectional view showing a further embodiment of the fuel cell according to the present invention;
[FIG. 16] FIG. 16 is a block diagram showing a circuit configuration for driving the fuel cell according to the present invention;

[FIG. 17] FIG. 17 is a graph for explaining of a drive control system handling attachment of the produced water;

[FIG. 18] FIG. 18 is a graph for explaining a drive system for changing balance of an amount of air supply and an amount of fuel supply;

[FIG. 19] FIG. 19 is a longitudinal sectional view showing a still further embodiment of the fuel cell according to the present invention; and

[FIG. 20] FIG. 20 is a longitudinal sectional view and a transverse sectional view of the fluid transfer device.

EXPLANATION OF REFERENCE NUMERALS

1       loop-like elastic body
11      flat plate part
12      circular arc part
13      slit aperture
14      slit aperture
15      loop-like elastic body piece
16      connecting piece
17      concave-convex surface
18      resin film
2       flow path wall
3       piezoelectric element
5       flow path wall
50      side wall
53      fuel supply tank
54      fuel collectiontank
55      produced water collection tank
56      circulation flow path wall
6       flow path
61      liquid flow path
62      gas flow path
7       MEA
8       fuel cell

BEST MODE FOR CARRYING OUT THE INVENTION

Embodiments of a fluid transfer device and a fuel cell according to the present invention are to be described in detail below with reference to the drawings.

[1] First fluid transfer device

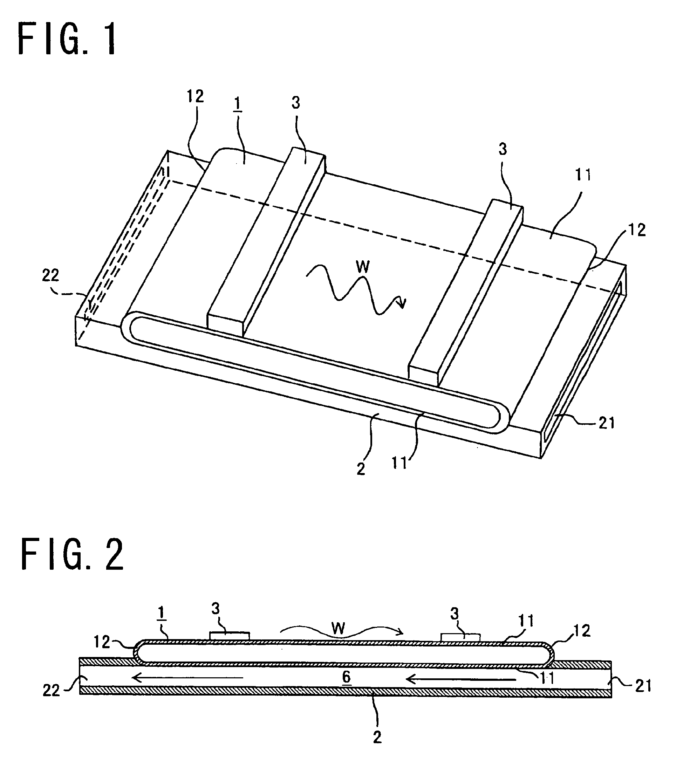

As shown in FIGS. 1 and 2, a first fluid transfer device according to the present invention comprises a loop-like elastic body 1 which has a loop-like shape, two band plate-like piezoelectric elements 3, 3 arranged on an upper surface of the loop-like elastic body 1 at a predetermined interval in a loop direction, and a flow path wall 2 arranged along a lower surface of the loop-like elastic body 1.

The loop-like elastic body 1 is made of aluminum, for example, and is formed by two flat plate parts 11, 11 parallel to each other and two circular arc parts 12, 12 connecting corresponding ends of both the flat plate parts 11, 11 to each other. The loop-like elastic body 1 has a flat shape in a thickness direction. The two piezoelectric elements 3, 3 are placed on a surface of one flat plate part 11, and a flow path 6 extending along the other flat plate part 11 is formed inside the flow path wall 2.

Loop-like means seamless continuousness, and the loop-like shape also includes a shape with a corner, without being limited to the shape of circular arc parts 12, 12 shown in FIG. 2.

In the above described fluid transfer device, when high frequency voltages (ultrasonic wave region) with phases different from each other are applied to the two piezoelectric elements 3, 3, a flexural traveling wave W that advances in the loop direction is generated in the loop-like elastic body 1.

Here, where Young's modulus of the elastic body 1 is E, a density of the elastic body 1 is p, a resonance frequency of the elastic body 1 is f, and a board thickness of the elastic body 1 is d, a wave length $\lambda$ of the flexural traveling wave can be calculated by a following arithmetic expression 1.
$$(\text{equation } 1)$$

$$\lambda = (\sqrt{\pi}/4\sqrt{3}) \cdot /\sqrt{(Cd/f)}$$

$$C = \sqrt{(E/\rho)}$$

Where a loop length of the loop-like elastic body 1 is L, in order to circulate a flexural traveling wave along the loop of the loop-like elastic body 1, it is necessary that a relation of L>2λ is satisfied, and in order to generate a flexural traveling wave with high efficiency, it is desirable that a width b of the piezoelectric element 3 in a direction along the loop of the loop-like elastic body 1 is λ/2 and a thickness t of the piezoelectric element 3 is close to the board thickness d of the elastic body 1 as much as possible.
A flexural vibration wave generated by one piezoelectric element and a flexural vibration wave generated by the other piezoelectric element can be represented by following arithmetic expressions 2 and 3 respectively, where ω is an angular velocity, k is a wave number, φ is a difference in phase angle, x is a coordinate of a traveling direction axis of the flexural vibration wave, and a is a center-distance of the two piezoelectric elements.

$$(\text{equation } 2)$$

$$A\sin(\omega t - kx) + A\sin(\omega t + kx)$$

$$(\text{equation } 3)$$

$$B\sin(\omega t - k(x+a) + \varphi) + B\sin(\omega t + k(x+a) + \varphi)$$

Here, a condition for generating only a flexural traveling wave in the loop-like elastic body is represented by following arithmetic expression 4, where n is an odd number (n=±1, ±3,...), and m is an even number (m=0, ±2, ±4,...) (refer to "New Edition Ultrasonic Motor" Triceps, "CD-WS132" page 17 to page 19).

$$(\text{equation } 4)$$

$$a = \lambda(n-m)/4$$

$$\varphi = \pi(n+m)/2 \quad (n \neq m)$$

$$A = B$$

When a flexural traveling wave is generated in the loop-like elastic body 1, the flexural traveling wave advances from an upper flat plate part 11 through a right side circular arc part 12 to a lower flat plate part 11, and then returns to the upper flat plate part 11 through a left side circular arc part 12 of the loop-like elastic body 1 shown in FIG. 2. Then, a fluid in the flow path 6 in contact with the lower flat plate part 11 is transferred from an inlet 21 to an outlet 22 of the flow path wall 2 by a flexural traveling wave advancing in the lower flat plate part 11.
In the above described fluid transfer device, with the simple configuration in which simply the loop-like elastic body 1 has a flat shape and the two band plate-like piezoelectric elements 3, 3 are placed on the surface of the loop-like elastic body 1, the fluid can be transferred along the flow path 6, realizing a decrease in thickness of the device. Also, the flexural traveling wave circulates along the loop of the loop-like elastic body 1, and moreover, there is no great difference in length for which the vibration is transmitted between the outer peripheral side and the inner peripheral side of the loop-like elastic body 1. Therefore, the flexural traveling wave is excited with extremely little energy loss, and as a result, a fluid can be transferred with higher efficiency than in conventional devices.

[2] Second fluid transfer device

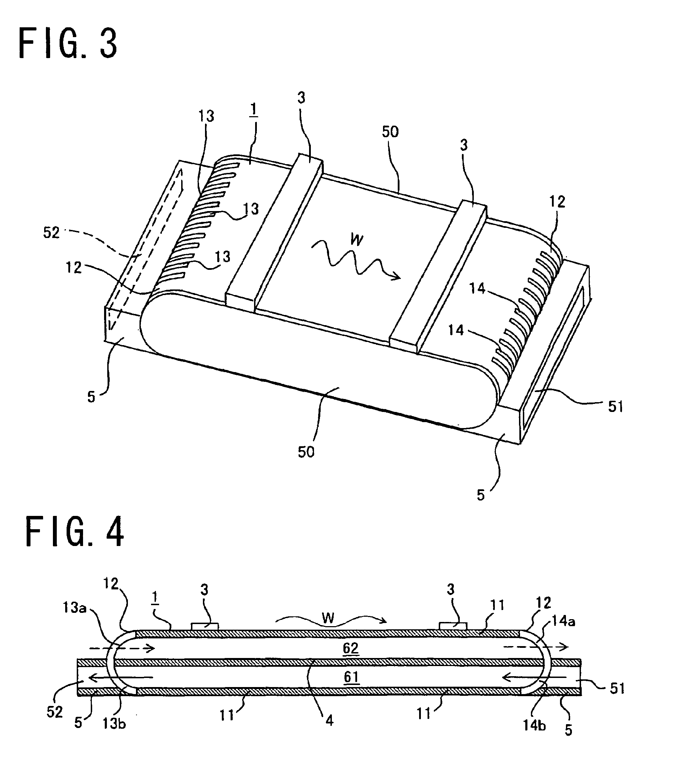

As shown in FIGS. 3 and 4, a second fluid transfer device according to the present invention comprises a loop-like elastic body 1 which has a loop-like shape, two band plate-like piezoelectric elements 3, 3 arranged on an upper surface of the loop-like elastic body 1 at a predetermined interval in a loop direction, a flow path wall 5 arranged along a lower surface of the loop-like elastic body 1, and a pair of side walls 50, 50 blocking an aperture on either side of the loop-like elastic body 1.

The loop-like elastic body 1 is made of aluminum, for example, and is formed by two flat plate parts 11, 11 parallel to each other and two circular arc parts 12, 12 connecting corresponding ends of both the flat plates part 11, 11 to each other. The loop-like elastic body 1 has a flat shape in a thickness direction. The two piezoelectric elements 3, 3 are placed on a surface of an upper flat plate part 11. Also, in an inner area surrounded by the loop-like elastic body 1, a partition wall 4 expanding parallel to both the flat plate parts 11, 11 is placed to divide the inner area vertically into two, and a liquid flow path 61 is formed below the partition wall 4 while a gas flow path 62 is formed above the partition wall 4. Loop-like means seamless continuousness, and the loop-like shape also includes a shape with a corner, without being limited to the shape of circular arc parts 12, 12 shown in FIG. 4.

A left side circular arc part 12 of the loop-like elastic body 1 is provided with a plurality of slit apertures 13 extending along an arc line, and a right side circular arc part 12 is provided with a plurality of slit apertures 14 extending along an arc line.
As shown in FIG. 4, slit apertures 14b, 13b arranged in a lower half crossing a liquid flow path 61 communicate with an inlet 51 and an outlet 52 of the flow path wall 5 respectively to form a liquid inlet to a liquid flow path 61 and a liquid outlet from the liquid flow path 61. Also, slit apertures 13a, 14a arranged in an upper half crossing the gas flow path 62 form a gas inlet to the gas flow path 62 and a gas outlet from the gas flow path 62, respectively.

In the above described fluid transfer device, when high frequency voltages (ultrasonic wave region) with phases different from each other are applied to two piezoelectric elements 3, 3, a flexural traveling wave W that advances in the loop direction is generated in the loop-like elastic body 1.
A condition for circulating the flexural traveling wave along the loop of the loop-like elastic body 1 is similar to in the first fluid transfer device described above.

When a flexural traveling wave is generated in the loop-like elastic body 1, the flexural traveling wave advances from an upper flat plate part 11 through a right side circular arc part 12 to a lower flat plate part 11, and then returns to the upper flat plate part 11 through a left side circular arc part 12 of the loop-like elastic body 1 shown in FIG. 4.
Then, a fluid in the liquid flow path 61 in contact with the lower flat plate part 11 is transferred from an inlet 51 to an outlet 52 of the flow path wall 5 by a flexural wave advancing in the lower flat plate part 11. In this process, the liquid flows into the liquid flow path 61 through the right side slit aperture 14b, and thereafter, it flows to the outside of the liquid flow path 61 through the left side slit aperture 13b.
Also, gas in the gas flow path 62 in contact with the upper flat plate part 11 is transferred by the flexural traveling wave advancing in the upper flat plate part 11, and the gas which has flowed from the left side slit aperture 13a into the gas flow path 62 flows from the right side slit aperture 14a to the outside of the gas flow path 62.

In the above described fluid transfer device, the liquid flow path 61 and the gas flow path 62 are formed inside the flat loop-like elastic body 1, and the two band plate-like piezoelectric elements 3, 3 are placed on the surface of the loop-like elastic body 1, realizing a decrease in thickness of the whole device.
Also, the inlet and the outlet of the fuel fluid and the air are formed by respective long slit apertures 13, 14 along an arc line of the circular arc part 12 of the loop-like elastic body 1. Therefore, in the process of advance of the flexural traveling wave in the loop-like elastic body 1, although a part of the flexural wave is reflected on one opening edge of the slit apertures 13, 14, the reflection is minor, and there is little energy loss with the reflection. Since the flexural traveling wave circulates along the loop of the loop-like elastic body 1, the fluid can be transferred with higher efficiency than in conventional devices.

[3] Fuel cell

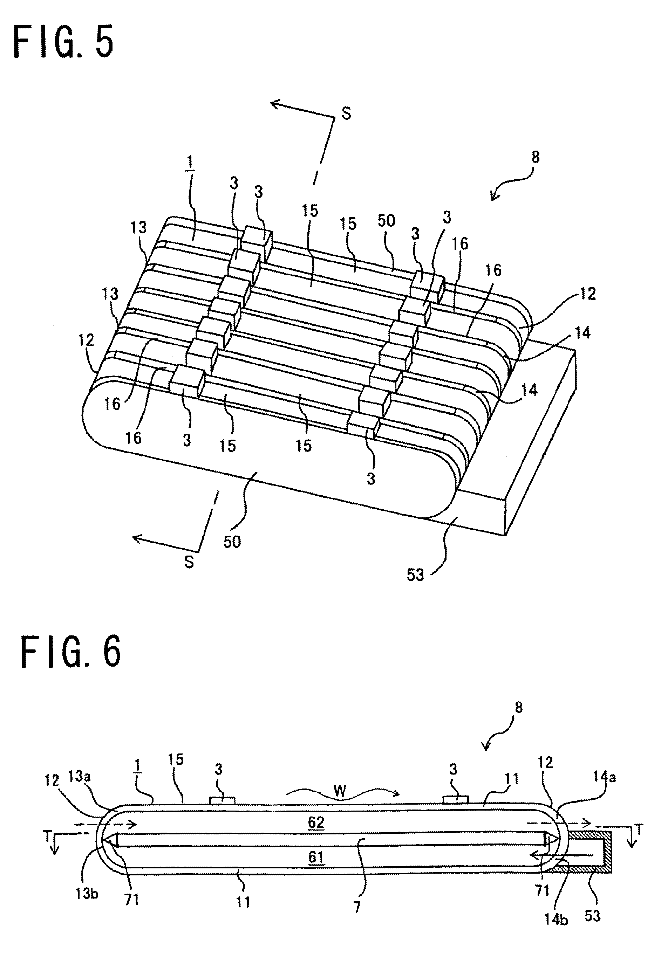

A fuel cell 8 according to the present invention comprises a fluid transfer device for supplying a fuel fluid (e.g., methanol) to a fuel electrode and supplying air to the other electrode of a membrane-electrode assembly (MEA) which includes the fuel electrode and an air electrode arranged on respective side of an electrolyte membrane. As shown in FIGS. 5 and 6, the fluid transfer device comprises a flat loop-like elastic body 1, a plurality of piezoelectric elements 3 to 3 arranged in two front and back lines at a predetermined interval in a loop direction on an upper surface of the loop-like elastic body 1, a pair of side walls 50, 50 blocking an aperture on either side of the loop-like elastic body 1, and a fuel supply tank 53.

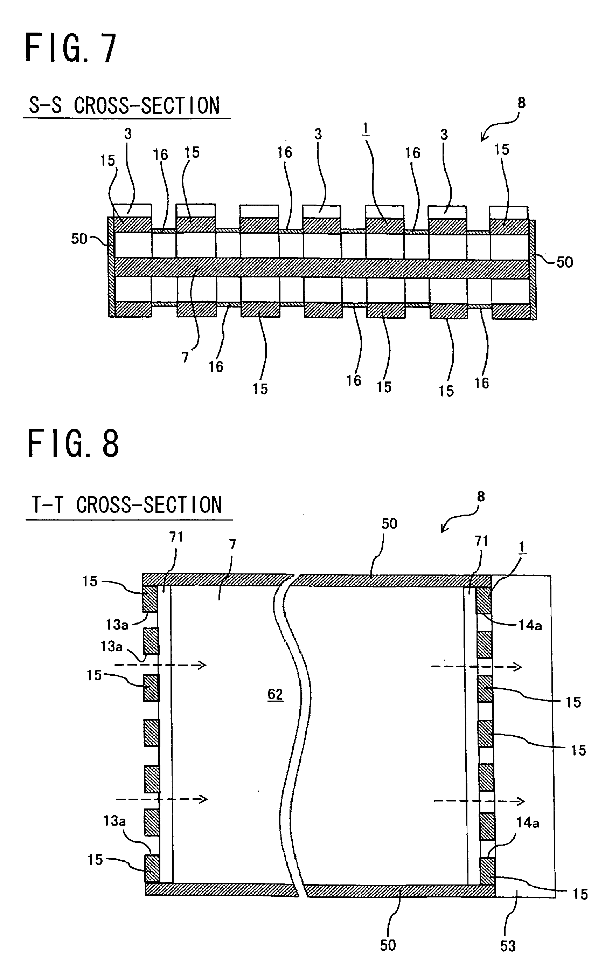

As shown in FIGS. 5 and 7, the loop-like elastic body 1 comprises a plurality of loop-like elastic body pieces 15 arranged parallel to each other at an interval, and a plurality of connecting pieces 16 connecting adjacent loop-like elastic body pieces 15, 15 to each other. The plurality of loop-like elastic body pieces 15 form two upper and lower flat plate parts 11, 11 extending parallel to each other, and two circular arc parts 12, 12 connecting corresponding ends of the flat plate parts 11, 11 to each other. The connecting piece 16 has a band plate-like shape, and a connection piece 16 extending along the upper flat plate part 11 of each loop-like elastic body piece 15 and a connection piece 16 extending along the lower flat plate part 11 work as a pair to connect adjacent loop-like elastic body pieces 15, 15 to each other. The plurality of piezoelectric elements 3 placed on respective loop-like elastic body pieces 15. The loop-like elastic body pieces 15 are made of aluminum, for example, and the connecting piece 16 is formed of a thin film of alcohol resistant rubber having an elastic coefficient sufficiently smaller than that of the loop-like elastic body piece 15. Loop-like means seamless continuousness, and the loop-like shape also includes a shape with a corner, without being limited to the shape of circular arc parts 12, 12 shown in FIG. 6.

As shown in FIG. 5, the upper and lower pair of connecting pieces 16, 16 of the loop-like elastic body 1 is missing in two arc-like areas between the circular arc parts 12, 12 of the loop-like elastic body pieces 15, 15 adjacent to each other. And the two arc-like areas form long and thin slit apertures 13, 14 in a similar way to in the second fluid transfer device.

As shown in FIG. 6, an MEA 7 is placed parallel to the upper and lower flat plate parts 11, 11 inside the loop-like elastic body 1, and both ends of the MEA 7 are supported to the loop-like elastic body piece 15 by a support member 71. An inner area of the loop-like elastic body 1 is thereby vertically into two, and a liquid flow path 61 is formed below the MEA 7 while a gas flow path 62 is formed above the MEA 7.

As a material of the support member 71, employed is, for example, an alcohol resistant rubber having an elastic coefficient sufficiently smaller than that of the loop-like elastic body piece 15. The support member 71 is formed in a thickness equal to or smaller than a thickness of the MEA 7. As the alcohol resistant rubber, known are chloroprene rubber, chlorosulfonated polyethylene, and the like.

It is also possible to employ an alcohol resistant plastic as well as the alcohol resistant rubber. As the alcohol resistant plastic, known are fluorine resin, polyphenylene sulfide resin, polyethersulfone resin, polyimide, polyacetal, ethylene vinylalcohol copolymer (EVOH) and the like.

The slit aperture 14b which is arranged in a lower half and crossing the liquid flow path 61 forms an inlet of the fuel fluid from the fuel supply tank 53 to the liquid flow path 61. Also, the slit apertures 13a, 14a which are arranged in an upper half and crossing the gas flow path 62 form an inlet of the air to the gas flow path 62 and an outlet of the air from the gas flow path 62, respectively.

In the above described fuel cell, when voltages with phases different from each other are applied to the two piezoelectric elements 3, 3 arranged on each loop-like elastic body piece 15 of the loop-like elastic body 1, a flexural traveling wave that advances in the loop direction is generated in each loop-like elastic body piece 15. The flexural traveling wave advances from the upper flat plate part 11 through a right side circular arc part 12 to the lower flat plate part 11, and then returns to the upper flat plate part 11 through a left side circular arc part 12 of the loop-like elastic body piece 15 shown in FIG. 6.

Here, since the rubber with a small elastic coefficient is employed as the support member 71 supporting the MEA 7, attenuation of the flexural traveling wave generated in the loop-like elastic body 1 is restrained.

Also, although a part of the flexural traveling wave advancing in the loop-like elastic body piece 15 collides to the connecting piece 16 to be reflected, since the connecting piece 16 is formed of the rubber with a small elastic coefficient, the reflection is minor, and there is little energy loss with the reflection.

Further, in the loop-like elastic body 1, the piezoelectric element 3 is placed on the flat plate part 11 in contact with the gas flow path 62. Therefore, in the flat plate part 11 in contact with the liquid flow path 61, attenuation of the flexural traveling wave occurred due to a contact with the fuel liquid is restrained.

The liquid in the liquid flow path 61 in contact with the lower flat plate part 11 is transferred from right side toward left side by the flexural traveling wave advancing in the lower flat plate part 11. Along with this, the fuel fluid in the fuel supply tank 53 flows into the liquid flow path 61 through the right side slit aperture 14b.

Also, the air in the gas flow path 62 in contact with the upper flat plate part 11 is transferred by the flexural wave advancing in the upper flat plate part 11. And as shown in FIG. 8, the air which has flowed from the left side slit aperture 13a into the gas flow path 62 flows from the right side slit aperture 14a to the outside of the gas flow path 62. In the process of flow of the fuel fluid through the liquid flow path 61, the fuel is supplied to the fuel electrode of the MEA 7, while, in the process of flow of the air through the gas flow path 62, oxygen is supplied to the air electrode of the MEA 7.

As a result, the MEA 7 generates electricity. Here, carbon dioxide gas produced in the liquid flow path 61 and water produced in the gas flow path 62 are carried away by the fluid flowing through the liquid flow path 61 and the gas flow path 62 to downstream and are eliminated, and therefore, the MEA 7 can obtain high power generation efficiency.

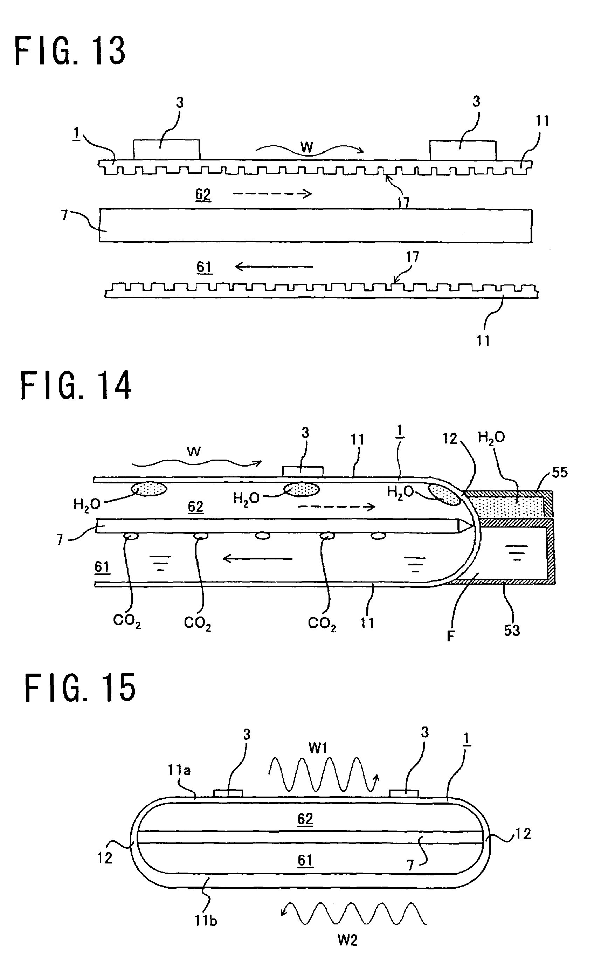

As shown in FIG. 13, in a case where a concave-convex surface 17 comprising minute concavity and convexity is formed on an inner surface of each of the two upper and lower flat plate parts 11, 11 of the loop-like elastic body 1, a flexural wave W is generated in the loop-like elastic body 1, and thereby a convex part of the concave-convex surface 17 has a high vibration rate. Therefore, the fluid flowing through the liquid flow path 61 and the gas flow path 62 receives impelling force from the convex part, and a flow velocity increases.

It is also possible to form the concave-convex surface 17 only one flat plate part 11 of the loop-like elastic body 1.

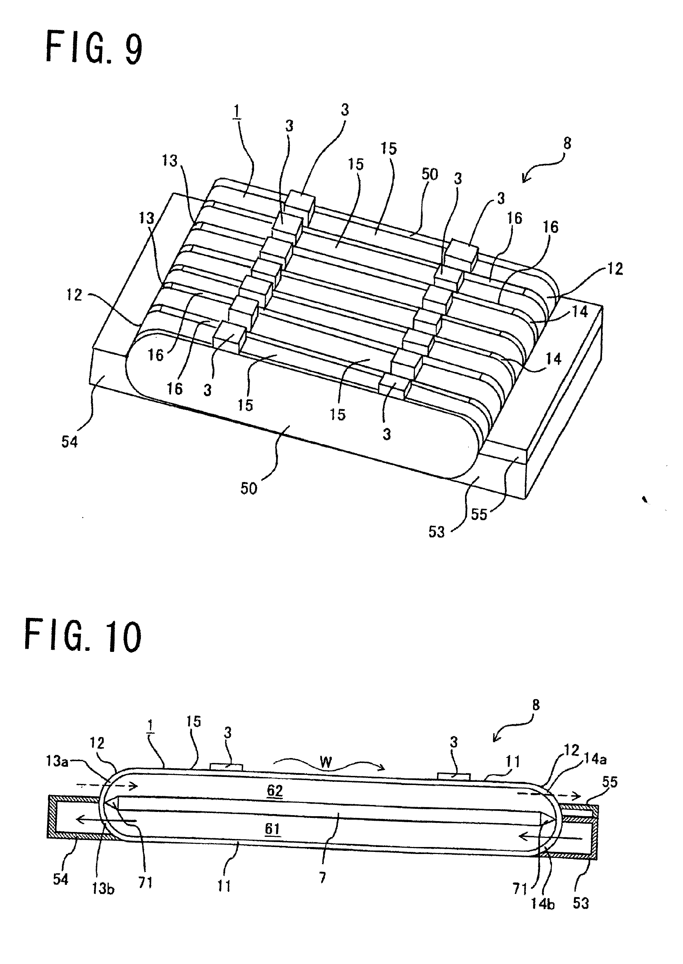

The fuel cell 8 shown in FIGS. 9 and 10 comprises the fuel supply tank 53, a produced water collection tank 55 and a fuel collection tank 54 connected to the loop-like elastic body 1. The fuel supply tank 53 is connected to the plurality of lower half slit apertures 14b which are the inlets of the liquid flow path 61, the fuel collection tank 54 is connected to the plurality of lower half slit apertures 13b which are the outlets of the liquid flow path 61, and the produced water collection tank 55 is connected to the plurality of upper half slit apertures 14a which are the outlets of the gas flow path 62.

Other configuration is similar to that of the fuel cell shown in FIG. 5.

According to the fuel cell 8 shown in FIGS. 9 and 10, the fuel fluid is supplied from the fuel supply tank 53 to the liquid flow path 61, and the fuel fluid which has passed the liquid flow path 61 is collected by the fuel collection tank 54. Also, as shown in FIG. 14, carbon dioxide gas produced in the liquid flow path 61 is carried away by a flow of a fuel F to downstream, and water which is produced in the gas flow path 62 and attached to the flat plate part 11 is moved forward by a traveling wave generated in the flat plate part 11, to be finally collected in the produced water collection tank 55.

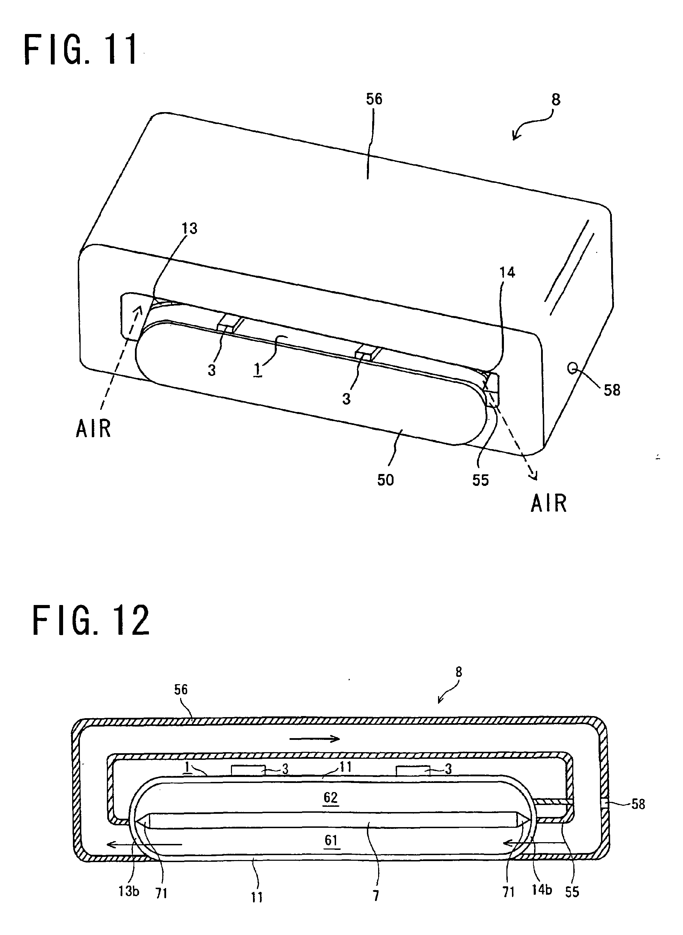

In the fuel cell 8 shown in FIGS. 11 and 12, the plurality of lower half slit apertures 14b which are the inlets of the liquid flow path 61 and the plurality of lower half slit apertures 13b which are the outlets of the liquid flow path 61 are connected to each other by a circulation flow path wall 56. The fuel cell 8 is configured so that the fuel fluid which has flowed out from the liquid flow path 61 through the lower half slit apertures 14b passes through the circulation flow path in the circulation flow path wall 56, and then returns to the liquid flow path 61 through the lower half slit apertures 13b.

Here, the circulation flow path wall 56 is formed so as to surround the two piezoelectric elements 3, 3 on the loop-like elastic body 1, and a side part of the circulation flow path wall 56 is provided with a fuel inlet 58.

According to the fuel cell 8 shown in FIGS. 11 and 12, the fuel fluid which has passed the liquid flow path 61 without reacting with the MEA 7 is circulated again to the liquid flow path 61 for reutilization of the fuel fluid. Here, the air flows in and flows out via the side of the fuel cell 8, using space formed between the loop-like elastic body 1 and circulation flow path wall 56 as shown in FIG. 11.

According to this fuel cell 8, since the two piezoelectric elements 3, 3 are covered by the circulation flow path wall 56, the piezoelectric elements 3, 3 can be protected from external action of force. Also, since a contour of the whole fuel cell 8 is determined by a shape of the circulation flow path wall 56, by forming the whole fuel cell 8 in, for example, rectangular parallelepiped, it is possible to utilize space effectively when incorporated in electrical devices or the like.

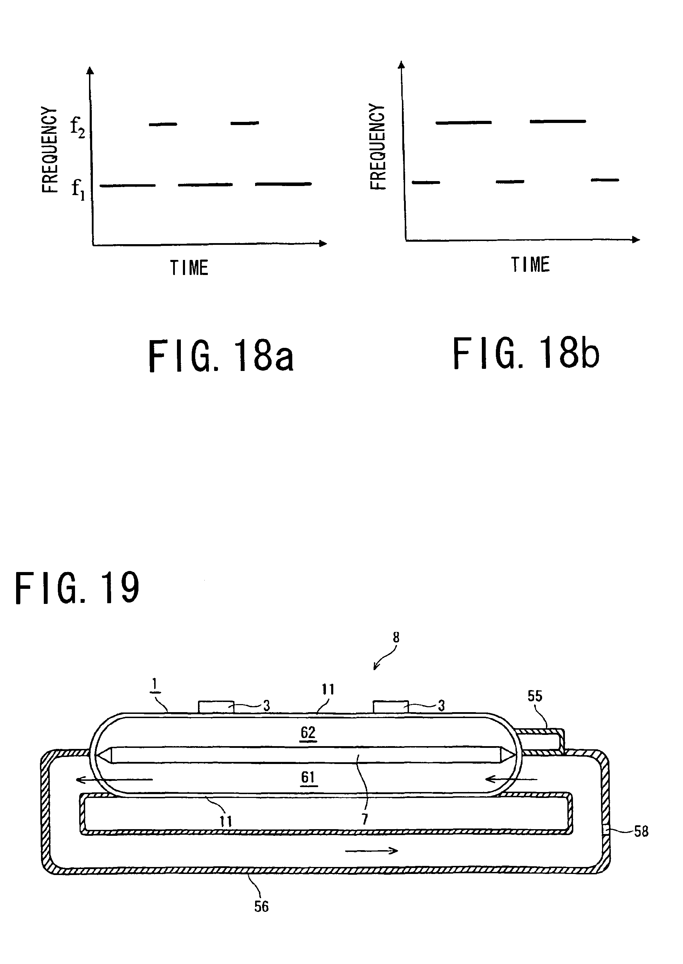

It is also possible to form the circulation flow path wall 56 below the loop-like elastic body 1 without surrounding the piezoelectric elements 3, 3 as shown in FIG. 19. The air can be thereby flowed in and flowed out smoothly, resulting in an increase in an amount of the air flow.

FIG. 15 shows an example in which there is a difference in board thicknesses of two upper and lower flat plate parts 11a, 11b forming the loop-like elastic body 1. In this example, the board thickness of the lower flat plate part 11b in contact with the liquid flow path 61 is greater than the board thickness of the upper flat plate part 11a in contact with the gas flow path 62 as shown in the figure. An amplitude of a flexural wave W1 generated in the upper flat plate part 11a is thereby greater than an amplitude of a flexural wave W2 generated in the lower flat plate part 11b.

Although the air has a low viscosity and is not likely to be affected by the flexural wave compared to the fuel fluid, the air receives sufficient impelling force from the flexural wave W1 having a great amplitude. In contrast, the fuel fluid has a high viscosity and is easy to be affected by the flexural wave, and therefore, the fuel fluid receives sufficient impelling force from the flexural wave W2 having a small amplitude. As a result, required supply amounts of the air and the fuel fluid can be secured.

Also, similar flow adjustment is possible with a configuration with a difference in the elastic coefficient between the upper flat plate part 11a and the lower flat plate part 11b.

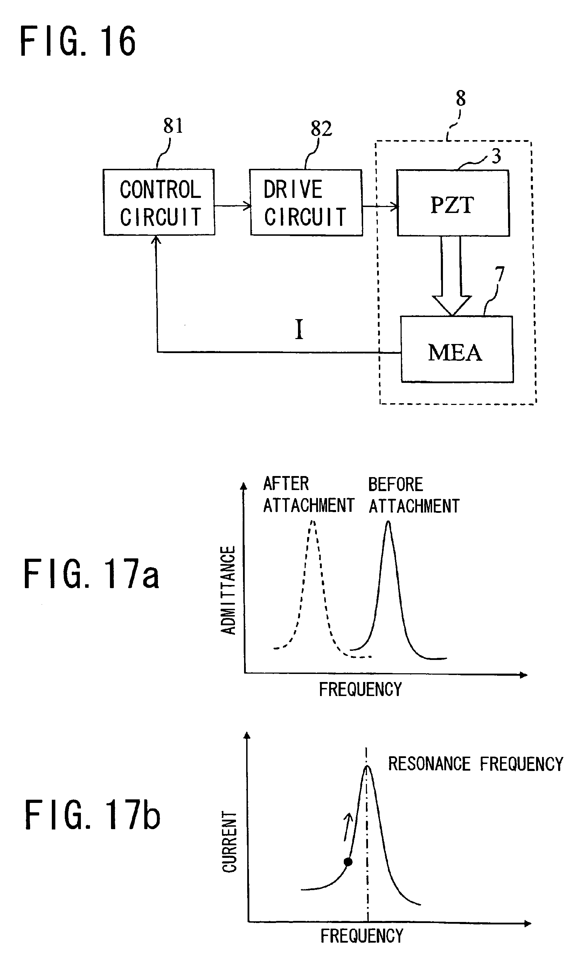

FIG. 16 shows a circuit configuration for operating the fuel cell 8 according to the present invention, a drive voltage is supplied from a drive circuit 82 to the piezoelectric element 3 arranged in the fuel cell 8. Also, a value of a current I provided from the MEA 7 is supplied to a control circuit 81, and the drive circuit 82 is controlled by the control circuit 81.

Here, if a voltage value for driving the piezoelectric element 3 is raised, the supply amounts of the air and the fuel can be increased. And if the voltage value for driving the piezoelectric element 3 is lowered, the supply amounts of the air and the fuel can be decreased.

More specifically, due to attachment of the produced water to the loop-like elastic body 1, frequency-admittance properties shift as shown in FIG. 17(a). And therefore, the frequency is adjusted by performing a follow-up control to drive the piezoelectric element at a resonance frequency shown in FIG. 17(b). Such a follow-up control can be implemented by, for example, using various search methods for searching a peak point of frequency-current characteristic, e.g., a mountain climbing method.

The power generation efficiency of the MEA 7 thereby improves.

Also, balance of the air supply amount and the fuel supply amount can be changed according to whether the air supply to the MEA 7 and the fuel fluid supply are sufficient.

It can be determined whether the air supply is sufficient by measuring oxygen density. The oxygen density can be measured by utilizing the fact that there is a constant relationship between the oxygen density and acoustic velocity. Supersonic velocity passing through the liquid flow path is measured, and then the oxygen density is calculated from the measurement result. Also, it can be determined whether the fuel fluid supply is sufficient by measuring methanol density. The methanol density can be measured by utilizing the fact that there is a constant relationship between the methanol density and acoustic velocity. For example, supersonic velocity passing through the gas flow path is measured, and the methanol density is calculated from the measurement result. In addition, the methanol density can be measured from specific gravity of the fuel fluid, infrared absorption amount or index of refraction.

The elastic body 1 has a plurality of resonance frequencies. Since the air has a low viscosity, the air can be transferred effectively by a drive at a high frequency. And since the fuel fluid has a high viscosity, the fuel fluid can be transferred effectively by a drive at a low frequency.

Therefore, in a drive system changing alternately a drive at a low resonance frequency f1 and a drive at a high resonance frequency f2 as shown in FIGS. 18(a), 18(b), in order to increase the fuel supply amount, a drive time at the low resonance frequency f1 is set to be long, and a drive time at the high resonance frequency f2 is set to be short as shown in FIG. 18(a). In contrast, in order to increase the air supply amount, a drive time at the low resonance frequency f1 is set to be short, and a drive time at the high resonance frequency f2 is set to be long as shown in FIG. 18(b).

According to the above described fuel cell 8, the loop-like elastic body 1 forming the fluid transfer device has a flat shape, and the liquid flow path 61 and the gas flow path 62 are formed inside the loop-like elastic body 1. Therefore, it is possible to decrease the size and thickness of the fluid transfer device, thereby realizing a decrease in the size and thickness of the fuel cell 8.

Also, since the flexural traveling wave generated in the loop-like elastic body 1 circulates through the loop-like elastic body 1 to perform effective excitation, the flexural traveling wave is generated with high energy efficiency, and the fluid can be transferred by a sufficient impelling force.

Therefore, the fuel cell 8 according to the present invention is preferred as a power supply of small electronic devices.

The present invention is not limited to the foregoing embodiment in construction but can be modified variously within the technical range set forth in the appended claims. For example, the configuration that is employed in one embodiment of the fluid transfer device or the fuel cell described above can also be employed in other embodiments. For the fuel to be supplied to the fuel electrode of the MEA, ethanol can be employed as well as methanol. Also, although exemplified is the fuel cell which supplies methanol directly as the fuel to be supplied to the fuel electrode of the MEA, the invention can be applied to a fuel cell which supplies hydrogen or a fuel containing hydrogen as a main component as a fuel (polymer electrolyte fuel cell, solid electrolyte fuel cell or the like) in a similar manner and an equivalent effect can be exerted.

The elastic body 1 described above may be formed of a metal body, a fluorinated resin or a polyimide resin having acid resistance, or a metal body and the fluorinated resin or the polyimide resin having acid resistance, or the like. Alternatively, it may be formed of single-crystal ceramics, multicrystal ceramics, glass ceramics, non-crystal ceramics or the like. The material of the elastic body 1 can be selected from these materials depending on resonance frequency or the like, and range of choices of resonance frequency or the like is expanded by using these materials.

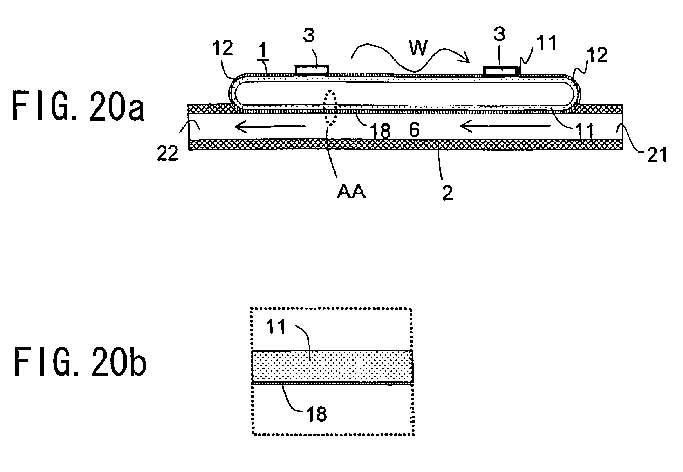

The loop-like elastic body 1 may have a structure in which a resin covers a metal body and a surface thereof in FIG. 2, FIG. 4, and FIG. 6. For example, it may be formed by a metal body (the flat plate part 11 and the circular arc part 12) and a layer of a resin (a resin film 18) covering a surface thereof like the example of the longitudinal sectional view of the fluid transfer device shown in FIG. 20(a). FIG. 20(b) is a transverse sectional view of a dashed line box portion AA of the fluid transfer device of FIG. 20(a). In the cross-section of FIG. 20(b), the cross-section area occupied by the resin is 1/100 to 1/10 of the cross-section area of the metal layer. By employing this configuration, although the metal body may be corroded by alcohol which is the fuel to be supplied to the fuel electrode of the MEA, the corrosion can be avoided by covering the surface with the resin layer. If the cross-section area which the resin occupies is too thick to the cross-section area of the metal layer, a possibility that the traveling waves spreading in two layers offset rises. And if it is too thin, a possibility that the metal body is corroded by alcohol rises.

The embodiment of the present invention can be suitably modified within the scope of the technical idea as defined in the appended claims.

**Claims**

1. A fluid transfer device comprising:

   a loop-like elastic body;
   at least two vibrating elements arranged on an outer peripheral surface or an inner peripheral surface of the elastic body along a loop direction; and
   at least one flow path formed in the outer peripheral surface of the elastic body along the loop direction,
   wherein by vibrating both the vibrating elements in phases different from each other and generating a flexural traveling wave that advances in the loop direction in the elastic body, a fluid in the flow path is transferred.

2. A fluid transfer device comprising:

   a loop-like elastic body;
   at least two vibrating elements arranged on an outer peripheral surface of the elastic body along a loop direction; and
   two flow paths that are formed along an inner peripheral surface of the elastic body and formed by dividing into two an inner area surrounded by the elastic body with a partition wall crossing a loop that the elastic body draws,
   wherein by vibrating both the vibrating elements in phases different from each other and generating a flexural traveling wave that advances in the loop direction in the elastic body, a fluid in each of the two flow paths is transferred.

3. The fluid transfer device according to claim 2, wherein the elastic body comprises two flat plate parts parallel to each other and two circular arc parts connecting corresponding ends of both the flat plate parts to each other, the partition wall is arranged parallel to the two flat plate parts, and the two circular arc parts are each provided with one or more apertures which is an inlet or an outlet of the two flow paths.

4. A fuel cell comprising a membrane-electrode assembly formed by a pair of electrodes arranged on either side of an electrolyte membrane, and a fluid transfer device supplying a fuel fluid to one electrode of the pair of electrodes of the membrane-electrode assembly and supplying an oxidizing fluid to the other electrode, the fluid transfer device comprising:

   a loop-like elastic body;
   at least two vibrating elements arranged on an outer peripheral surface of the elastic body along a loop direction;
   two flow paths which are formed along an inner peripheral surface of the elastic body and formed by dividing into two an internal area surrounded by the elastic body with the membrane-electrode assembly placed in the internal area in such a posture that the membrane-electrode assembly crosses a loop that the elastic body draws,
   wherein by vibrating both the vibrating elements in phases different from each other and generating a flexural traveling wave that advances in the loop direction in the elastic body, the fuel fluid is transferred along one flow path, and the oxidizing fluid is transferred along the other flow path.

5. The fuel cell according to claim 4, wherein the elastic body comprises two flat plate parts parallel to each other and two circular arc parts connecting corresponding ends of both the flat plate parts to each other, the membrane-electrode assembly is arranged parallel to the two flat plate parts, and the two circular arc parts are each provided with one or more apertures which is an inlet or an outlet of the two flow paths.

6. The fuel cell according to claim 5, wherein the elastic body comprises a plurality of loop-like elastic body pieces arranged parallel to each other at an interval, one or more connection pieces connecting the loop-like elastic body pieces to each other, and the connection piece is provided with the aperture.

7. The fuel cell according to any one of claims 4 to 6, wherein, of the two flow paths, a fuel supply tank is connected to the inlet of the flow path transferring the fuel fluid, and a produced water collection tank is connected to the outlet of the flow path transferring the oxidizing fluid.

8. The fuel cell according to any one of claims 4 to 6, wherein, of the two flow paths, the inlet and the outlet of the flow path transferring the fuel fluid are connected to each other by a circulation flow path, and the fuel fluid which flows out from the outlet is supplied to the inlet.

9. The fuel cell according to any one of claims 4 to 6, wherein the inner peripheral surface of the elastic body is provided with concavity and convexity having a difference in level in a flow path direction along at least one flow path of the two flow paths.

# FIG. 1

# FIG. 2

# FIG. 3

# FIG. 4

# FIG. 5

# FIG. 6

# FIG. 7

## S-S CROSS-SECTION

# FIG. 8

## T-T CROSS-SECTION

# FIG. 9

# FIG. 10

# FIG. 11

# FIG. 12

## FIG. 13

## FIG. 14

## FIG. 15

# FIG. 16

# FIG. 17a

# FIG. 17b

FIG. 18a  FIG. 18b

FIG. 19

FIG. 20a

FIG. 20b

## INTERNATIONAL SEARCH REPORT

| International application No. |
|---|
| PCT/JP2008/067465 |

A.  CLASSIFICATION OF SUBJECT MATTER
*F04D33/00(2006.01)i, H01M8/04(2006.01)i*

According to International Patent Classification (IPC) or to both national classification and IPC

B.  FIELDS SEARCHED

Minimum documentation searched (classification system followed by classification symbols)
F04D33/00, H01M8/04

Documentation searched other than minimum documentation to the extent that such documents are included in the fields searched
Jitsuyo Shinan Koho        1922-1996   Jitsuyo Shinan Toroku Koho   1996-2008
Kokai Jitsuyo Shinan Koho  1971-2008   Toroku Jitsuyo Shinan Koho   1994-2008

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 2005-282541 A  (Sanyo Electric Co., Ltd.), 13 October, 2005 (13.10.05), Full text; Figs. 1 to 10 (Family: none) | 1-9 |
| A | JP 2006-269363 A  (Sanyo Electric Co., Ltd.), 05 October, 2006 (05.10.06), Full text; Figs. 1 to 8 (Family: none) | 1-9 |
| A | JP 2004-36471 A  (Hitachi, Ltd.), 05 February, 2004 (05.02.04), Full text; Figs. 1 to 7 (Family: none) | 1-9 |

| ☒  Further documents are listed in the continuation of Box C. | ☐  See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered  to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 01 December, 2008 (01.12.08) | 09 December, 2008 (09.12.08) |

| Name and mailing address of the ISA/ Japanese Patent Office | Authorized officer |
|---|---|
| Facsimile No. | Telephone No. |

Form PCT/ISA/210 (second sheet) (April 2007)

**INTERNATIONAL SEARCH REPORT**

International application No.

PCT/JP2008/067465

C (Continuation).    DOCUMENTS CONSIDERED TO BE RELEVANT

| Category* | Citation of document, with indication, where appropriate, of the relevant passages | Relevant to claim No. |
|---|---|---|
| A | JP 3-134300 A  (Toyoda Automatic Loom Works, Ltd.), 07 June, 1991 (07.06.91), Full text; Figs. 1 to 7 (Family: none) | 1-9 |
| A | JP 3-149373 A  (Hitachi, Ltd.), 25 June, 1991 (25.06.91), Full text; Figs. 1 to 5 (Family: none) | 1-9 |
| A | JP 2005-214138 A  (Daikin Industries, Ltd.), 11 August, 2005 (11.08.05), Full text; Figs. 1 to 16 (Family: none) | 1-9 |
| A | JP 5-106562 A  (Osaka Vacuum Ltd.), 27 April, 1993 (27.04.93), Full text; Figs. 1 to 7 (Family: none) | 1-9 |
| A | JP 2004-150438 A  (Hewlett-Packard Development Co., L.P.), 27 May, 2004 (27.05.04), Full text; Figs. 1 to 8 & US 2004/0086400 A1    & EP 1418003 A1 | 1-9 |

Form PCT/ISA/210 (continuation of second sheet) (April 2007)

## REFERENCES CITED IN THE DESCRIPTION

**Patent documents cited in the description**

- JP 2006242176 A

- JP 2006269363 A

**Non-patent literature cited in the description**

- New Edition Ultrasonic Motor. Triceps, ''CD-WS132''. 15-22